# EUROPEAN PATENT SPECIFICATION

(11) **EP 3 644 694 B1**
(45) Date of publication and mention of the grant of the patent: **25.08.2021**
(21) Application number: 18202438.0
(22) Date of filing: 24.10.2018
(51) Int. Cl.: H05K 7/14, H02B 1/06, H02B 1/14, H02B 1/015

(54) **PLUG AND TERMINAL COVER FOR MODULAR ENCLOSURE**
STECKER UND KLEMMENABDECKUNG FÜR MODULGEHÄUSE
FICHE ET CACHE-BORNES POUR BOÎTIER MODULAIRE

(43) Date of publication of application: 29.04.2020
(73) Proprietor: Radzikowski, Robert, 04-205 Warszawa (PL)
(72) Inventor: Teluk, Marek, 01-990 Warszawa (PL); Kubaszewski, Miroslaw, 01-842 Warszawa (PL)
(74) Representative: Wroblewski, Marcin Jan

(56) References cited:
- EP-A1- 1 912 285
- EP-A1- 2 213 149
- DE-A1- 10 036 622
- DE-U1-202015 105 393

## Description

### Technical Field

The subject of the invention is a plug and a terminal cover for a modular enclosure of an electrical and/or electronic device, in particular a modular enclosure for a DIN 35mm rail.

### State of the Art

The commonly used DIN 35mm rail terminal covers comprise rectangular apertures which allow for the power supply and connection of electronics with other external devices. These apertures may comprise screw fastenings, plug fastenings, RJ or USB sockets. These apertures are sometimes open, if the enclosure has large and non-standard connectors built into it, or partly closed when screw fastenings are used. These apertures may also be completely closed. In most cases, however, they are used for mounting terminal strips with multiple conductors, some of which are accessible and used, and some that should be masked and hidden from the user. This can be achieved using clip-on covers.

The terminal covers which are in use at the present time are usually equipped with pre-cut apertures and teeth which are broken out of the enclosure terminal cover of an electrical / electronic device being assembled. This action causes irreversible changes in the construction of the terminal cover, as a result making it a disposable element as it is not possible to re-fit the broken teeth and apertures again. This problem is especially evident in the popular series of apertures in DIN terminal covers manufactured by companies like Italtronic, Camdenboss, OKW or Gainta. Furthermore, in order to break off these elements, the use of appropriate tools is necessary.

The Chinese utility model CN206821091 presents an enclosure which can be mounted on a rail using a groove in its bottom part. The said enclosure is equipped with two protective shields, one of which is mounted on hinges. In addition, one of the shields has fixing holes and cable outlets.

The European patent EP2213149B1 reveals a multifunctional enclosure for electrical and/or electronic devices which is mounted on a DIN rail equipped with shields designed to protect electrical connectors against access by unauthorized persons, and the shields are equipped with ports placed on one of their surfaces.

There is also the Chinese utility model CN205546239 which describes a modular enclosure for electrical equipment that can be mounted on a rail, it has side walls equipped with apertures for power cords and holes for locating clamping screws.

European patent application EP1912285A1 describes the device that has a locking unit provided for locking an inserted connector and arranged at a housing in an area within a plug connection in a pivotable manner. The locking unit is designed in U-shape and has a U-ridge covering the connector and a U-side piece designed as a resting unit, where the U-side piece overlaps a front edge of the connector. The locking unit has another U-side piece engaging a rear edge of the connector, and has a rotational axis that is arranged in a transition area of the ridge to the latter side piece.

German patent application DE10036622A1 describes a casing cover which is located over a section of cable channel. By joining several casings together, a continuous cable channel is assembled from the sections.

German utility model DE202015105393U1 describes a connection device, in particular single or row several times connector plug, with a housing of a non-conducting plastic. It comprises one or more formed contact terminals in the housing, in each of which an electrical conductor is insertable. One or more contact terminals comprises a receptacle in which a male means in a plugging direction is insertable. A plurality of or all of the receptacles in each case with a releasable cover are provided integrally with the case.

These terminal covers make it easier to mount electrical or electronic devices on a rail, but they do not provide full protection against access of unauthorized persons because they neglect to provide sealing for the unused apertures.

Therefore, it is advisable to create a solution that does not require breaking off the elements of the terminal cover in order to mount the devices while making it possible to seal the selected fields of the terminal cover again.

### Summary of the Invention

The first aspect of the invention is the plug adapted for insertion into a terminal cover for a modular enclosure of an electrical and/or electronic device, comprising a body to be inserted into grooves of the terminal cover. The body is equipped with a projection adapted for sealing apertures in the terminal cover which provide access to screws in the terminal strip of the enclosure. The plug also comprises a tooth adapted for plugging a wire access area within a wire access space to the terminal strip of the enclosure.

Preferably, the plug comprises at least two connectors.

Preferably, the body of the plug comprises a bevel.

Preferably, the plug comprises a cylinder placed coaxially to the projection.

The plugs preferably form a plug pack comprising at least two plugs, preferably three, connected with help of connectors.

The invention also relates to a terminal cover for a modular enclosure of an electrical / electronic device adapted to receive at least one plug according to the first aspect of the invention or at least one plug pack according to the first aspect of the invention. The terminal cover comprises a body in the form of an elongated angle fitting whose first element, which is the first arm of the angle fitting, comprises apertures providing access to screws in a terminal strip and adapted to receive projections of plugs, while the second element, which is the second arm of the angle fitting, comprises on its inner side, grooves adapted to receive plug bodies with a light interference fit and second element comprises protruding terminal bars which, together with the edge of the second element of the terminal cover, form the wire access space to the terminal.

Preferably, the apertures of the terminal cover also comprise grooves for receiving connectors.

Preferably, the terminal cover comprises mounting walls and a fastening clip for mounting the terminal cover to the enclosure.

Preferably, the terminal cover comprises a recess for a screwdriver used for disconnecting the terminal cover from the enclosure.

Further, the invention relates to a kit comprising at least one plug or at least one plug pack according to the first aspect of the invention as well as at least one terminal cover according to the invention.

Another aspect of the invention is also a modular enclosure of an electrical and/or electronic device comprising at least one plug according to the first aspect of the invention or at least one plug pack and at least one terminal cover according to the invention.

Preferably, the modular enclosure is adapted to be mounted to a DIN rail.

The solution according to the invention in the form of elements working closely together in the form of a seal and a terminal cover eliminates the necessity to break off elements of the terminal cover for mounting electrical and / or electronic devices, while providing an easy and quick way to seal the selected fields of the terminal cover again.

The described solution allows time to be saved during installation of cables in an electrical and/or electronic device as well as to ensure an aesthetic look of the enclosure as this solution does not necessitate making apertures and breaking off teeth in the said enclosure, as a result of which the edges of the apertures are not jagged. The conducted tests also showed that the time used for plugging three apertures with the finished element is about 3 seconds, while making three apertures and breaking off three teeth in the traditional enclosures using a screwdriver takes about 40 seconds.

The versatility of the plugs, according to the invention, lies in the fact that the same plugs in a given series can be used in terminal covers with a various number of fields as well as in enclosures equipped with these terminal covers.

Furthermore, the plug according to the invention allows for covering and uncovering any fields, thus allowing users to change the conception as the electrical connections are being created, while the traditional methods, once the hole and the tooth are broken off the enclosure, do not allow for this option. The solution according to the invention is also cheaper than the currently used solutions because each of the plugs can be used multiple times for plugging into any of the fields in the terminal cover.

The subject of the invention has been shown in the embodiment drawing, where:

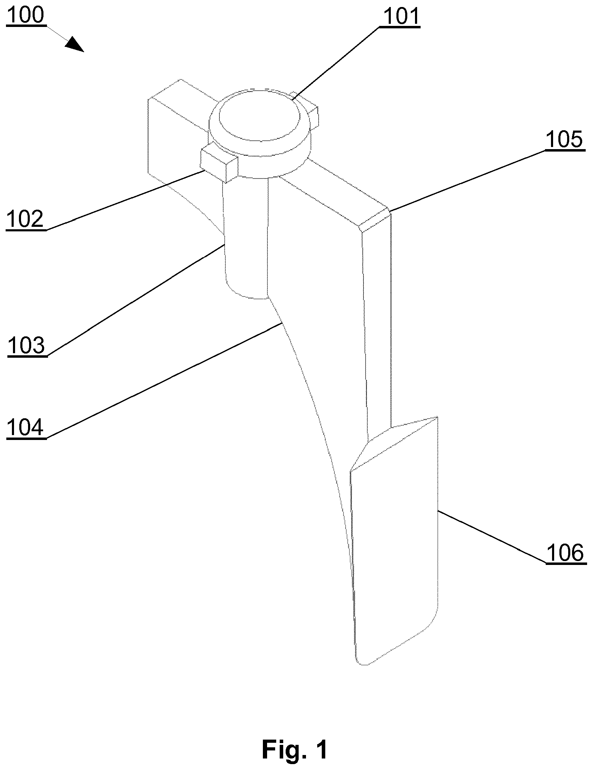

Fig. 1 shows the perspective view of the plug according to the invention;
Fig. 2 shows the perspective view of the terminal cover according to the invention;
Fig. 3 shows the assembly view of the terminal cover with the plugs connected according to the invention;
Fig. 4 A-F show the terminal cover with the plug pack connected, according to the invention, in the respective views: perspective from cross-section (A), (B) frontal perspective view (C), frontal view (D), side view (E) and top view (F);
Fig. 5A shows the assembly view of the modular enclosure of an electrical and/or electronic device with the terminal cover and plugs according to the invention;
Fig. 5B shows the modular enclosure of an electrical and/or electronic device with the terminal cover and the plugs, according to the invention, after all of the elements have been assembled;
Fig. 6 shows a pack of three plugs with the connectors;
Fig 7. shows sets of the terminal covers with the fields of 9, 12, and 15 plugs respectively according to the invention;

### Embodiments of the invention

### Embodiment 1

The plug 100 adapted to be embedded in the terminal cover 200 has the form of a flat body 104 which is 1.5 mm thick comprising a projection 101 adapted for plugging apertures 208 which provide access to the screws 401 of the terminal strip 400. Each projection 101 has two connectors 102 which allow for making many plugs 100 in the technological process. Connectors 102 make it easier to plug the apertures 208 when using multiple individual plugs connected together. In the case of a simultaneous insertion of several identical plugs 100, the connectors 102 allow for creating a pack 100a of plugs 100. Furthermore, the projection 101 is connected to the technological cylinder 103 which makes it easier to mould the plug during production and strengthens its structure. The body 104 also has a tooth 106 and a sleeve 105 located between the cylinder 103 and the tooth 106. The technological sleeve 105 makes it possible to slide the plugs 100 to the end of the grooves 206 in the terminal cover 200, so that it fills the opening 208 which is the access to the screws 401 of the terminal strip 400 and the access space 204 to the terminal strip 400 without becoming jammed on the sharp corners of the inner shape of the terminal cover 200.

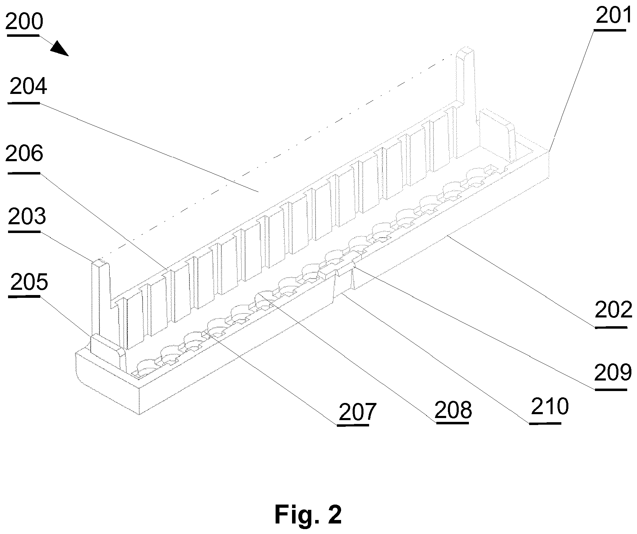

Fig. 2 shows the terminal cover 200 with 15 fields which is an angle fitting, rectangular in form, intended to be inserted in the dedicated places of the enclosure 300. It comprises the body 201, front 202, and terminal bars 203 which complement the area resulting from the width of the terminal cover 200 (along with the change of module M), and the number of tracks while simultaneously forming the access space 204 to the terminal strip 400. This space is adapted for connecting teeth 106 and plugs 100. Furthermore, the terminal cover 200 comprises mounting walls 205 which make it possible to clip it on the enclosure 300, grooves 206 adapted to receive plug 100 bodies 104 with a light interference fit, as well as additional technological grooves 207 adapted to the plug 100 connectors 102. The terminal cover 200 also comprises apertures 208 which provide the access area to the screws 401 of the terminal strip 400 which, when needed, are sealed using the projections 101 and plugs 100. Furthermore, the terminal cover 200 comprises a fastening clip 209 and recess 210 for a screwdriver which make it possible to mount the terminal cover 200 to the enclosure 300 as well as ease of disassembly by prying it with the screwdriver and disconnecting it.

### Embodiment 2

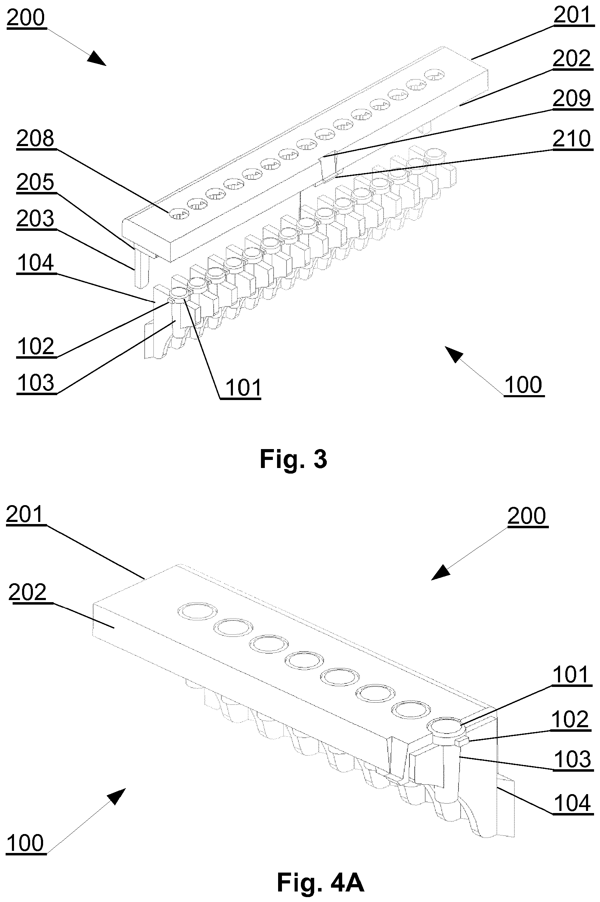

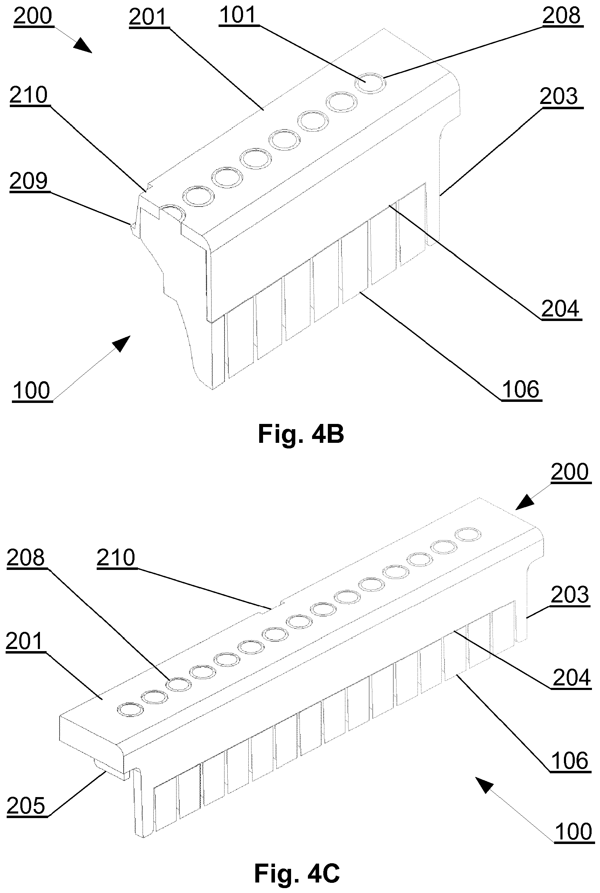

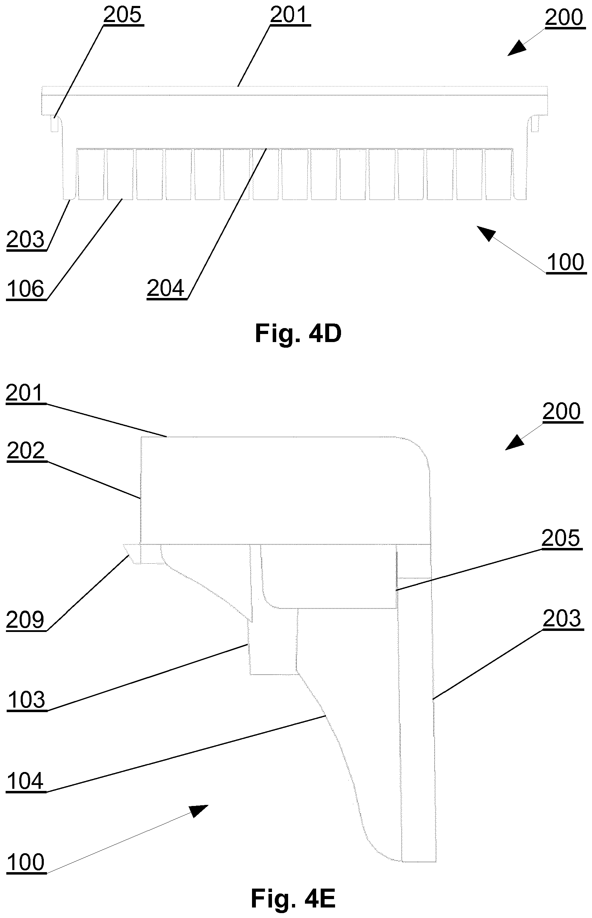

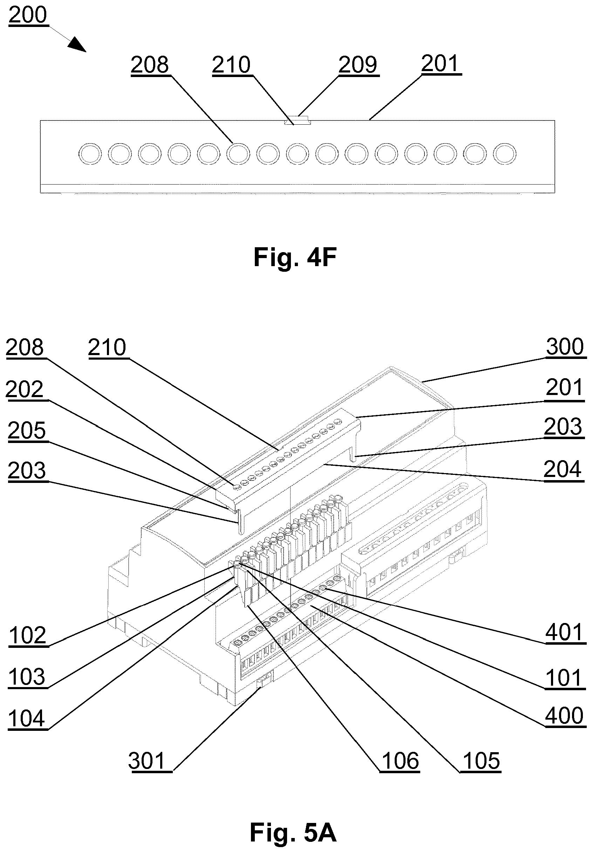

Fig. 3 and Fig. 4 C-D show the terminal cover 200 along with 5 packs comprising 3 plugs 100 each. In this embodiment all of the apertures 208 which provide access to the screws 401 of the terminal strip 400 are sealed along with the entire access space 204 to the terminal strip 400.

### Embodiment 3

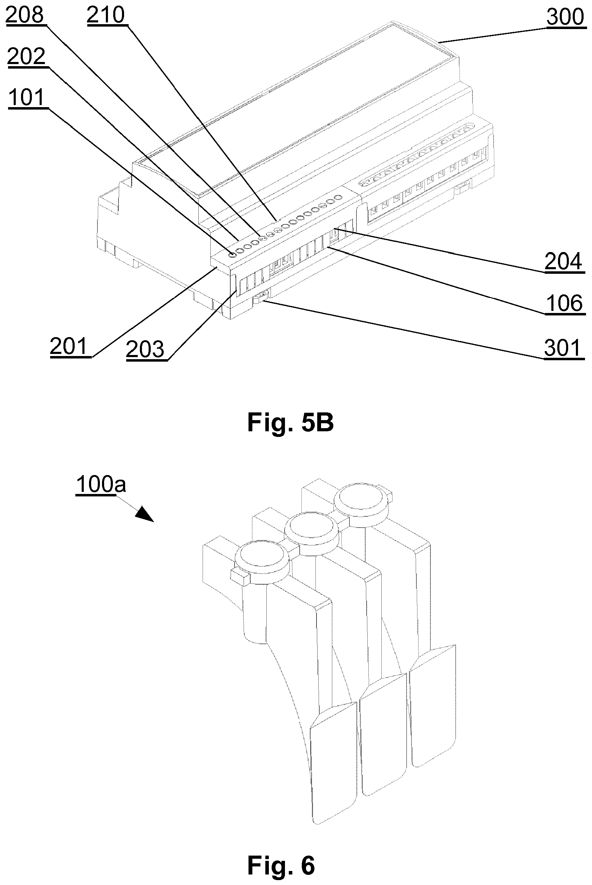

Fig. 5A and Fig. 5B show the modular enclosure 300 of an electrical and/or electronic device with fastening clips 301 which make it possible to mount it on a DIN rail and unmount it easily. The enclosure 300 comprises the plugs 100 and the terminal cover 200. The said enclosure 300 is a 10M enclosure, i.e. a 10-module enclosure with the length that meets the DIN43880 standard, mounted on a DIN rail, for example a DIN 35mm rail.

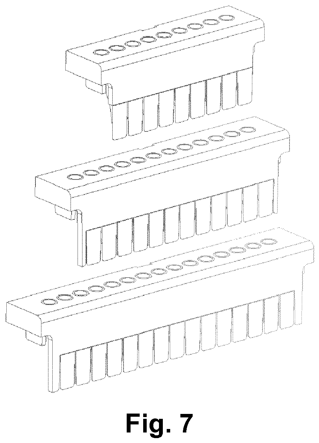

The terminal cover, according to the invention, can be used, for example, as a 5M terminal cover with 15 fields in the 0.2" pitch that is 5.08" which is dedicated for 0.2" connectors, and conditionally 5 mm, designated for 300V voltage, 10A currents and wires with cross-sections up to 2.5". The plugs, according to the invention, can be used in different terminal covers and enclosures equipped with terminal covers, as indicated in Table 1 and Fig. 7.

**Table 1. Summary on the use of a plug in various terminal covers.**

| Terminal cover | Number of fields (plugs) / number of triple plugs | Matching enclosures |
|---|---|---|
| 3M | 9/3 | 3M, 6M, 9M |
| 4M | 12/4 | 4M, 8M, 12M |
| 5M | 15/5 | 5M, 10M |

## Claims

1. Plug (100) adapted for inserting into a terminal cover (200) for a modular enclosure of an electrical and/or electronic device, **characterized in that** it comprises a body (104) to be inserted in grooves (206) of the terminal cover (200), wherein said body is equipped with a projection (101) adapted for sealing apertures (208) in the terminal cover (200) which provide access to screws (401) in a terminal strip (400) of the enclosure (300) and a tooth (106) adapted for sealing a wire access area within a wire access space (204) to the terminal strip (400) of the enclosure (300).

2. Plug (100), according to claim 1, **characterized in that** it comprises at least two connectors (102).

3. Plug (100), according to claim 1 or 2, **characterized in that** the body (104) of the plug (100) comprises a bevel (105).

4. Plug (100) according to claim 1 or 2, **characterized in that** it comprises a cylinder (103) placed coaxially to the projection (101).

5. Pack (100a) of plugs **characterized in that** it comprises at least two plugs (100) according to any of the claims from 1 to 4, preferably three, connected with help of connectors (102).

6. Terminal cover (200) for a modular enclosure (300) of an electrical and/or electronic device adapted to receive at least one plug (100) according to any of the claims 1 - 4 or at least one plug pack according to claim 5 wherein it comprises a body (201) in the form of an elongated angle fitting whose first element, which is the first arm of the angle fitting, comprises apertures (208) providing access to screws (401) in the terminal strip (400) and adapted to receive projections (101) of plugs (100), while the second element, which is the second arm of the angle fitting, comprises on its inner side grooves (206) adapted to receive plug (100) bodies (104) with a light interference fit and the second element comprises protruding terminal bars (203) which, together with the edge of the second element of the terminal cover (200), form the wire access space (204) to the terminal strip (400).

7. Terminal cover (200) according to claim 6 , **characterized in that** the apertures (208) also comprise grooves (207) for receiving connectors (102).

8. Terminal cover (200) according to claim 6 or 7 , **characterized in that** it comprises mounting walls (205) and a fastening clip (209) for mounting the terminal cover (200) to the enclosure (300).

9. Terminal cover (200) according to any of the claims 6 - 8, **characterized in that** it comprises a recess (210) for a screwdriver used for disconnecting the terminal cover (200) from the enclosure (300).

10. Kit comprising at least one plug (100) according to any of the claims 1 - 4 or at least one plug pack according to claim 5 as well as at least one terminal cover (200) according to any of the claims 6 - 9.

11. Modular enclosure (300) of an electrical and/or electronic device, **characterized in that** it comprises at least one plug (100) according to any of the claims 1 - 4 or at least one plug pack according to claim 5 as well as at least one terminal cover (200) according to any of the claims 6 - 9.

12. Modular enclosure (300) according to claim 11, **characterized in that** it is adapted to be mounted on a DIN rail.

## Patentansprüche

1. Stecker (100), der zum Einsetzen in eine Klemmenabdeckung (200) für ein modulares Gehäuse eines elektrischen und/oder elektronischen Geräts angepasst ist, **dadurch gekennzeichnet, dass** er einen Körper (104) umfasst, der in Nuten (206) der Klemmenabdeckung (200) eingesetzt wird, wobei der Körper mit einem Vorsprung (101) ausgestattet ist, der zum Abdichten von Öffnungen (208) in der Klemmenabdeckung (200) angepasst ist, die Zugang zu Schrauben (401) in einer Anschlussleiste (400) des Gehäuses (300) bereitstellen, und einem Zahn (106), der zum Abdichten eines Drahtzugangsbereichs innerhalb eines Drahtzugangsraums (204) zu der Anschlussleiste (400) des Gehäuses (300) angepasst ist.

2. Stecker (100) nach Anspruch 1, **dadurch gekennzeichnet, dass** er mindestens zwei Anschlüsse (102) umfasst.

3. Stecker (100) nach Anspruch 1 oder 2, **dadurch gekennzeichnet, dass** der Körper (104) des Steckers (100) eine Abschrägung (105) aufweist.

4. Stecker (100) nach Anspruch 1 oder 2, **dadurch gekennzeichnet, dass** er einen Zylinder (103) aufweist, der koaxial zum Vorsprung (101) angeordnet ist.

5. Steckerpackung (100a), **dadurch gekennzeichnet, dass** sie mindestens zwei, vorzugsweise drei, Stecker (100) nach einem der Ansprüche 1 bis 4 umfasst, die mit Hilfe von Anschlüssen (102) verbunden sind.

6. Klemmenabdeckung (200) für ein modulares Gehäuse (300) eines elektrischen und/oder elektronischen Geräts, das zur Aufnahme mindestens eines Steckers (100) nach einem der Ansprüche 1 bis 4 oder mindestens einer Steckerpackung nach Anspruch 5 geeignet ist, wobei sie einen Körper (201) in Form eines länglichen Winkelbeschlags aufweist, dessen erstes Element, das den ersten Arm des Winkelbeschlags darstellt, Öffnungen (208) aufweist, die den Zugang zu Schrauben (401) in der Klemmleiste (400) ermöglichen und zur Aufnahme von Vorsprüngen (101) von Steckern (100) geeignet sind, während das zweite Element, das der zweite Arm des Winkelanschlusses ist, an seiner Innenseite Nuten (206) aufweist, die angepasst sind, um die Körper (104) von Steckern (100) mit einer leichten Presspassung aufzunehmen, und das zweite Element vorstehende Anschlussleisten (203) aufweist, die zusammen mit dem Rand des zweiten Elements der Klemmenabdeckung (200) den Drahtzugangsraum (204) zur Anschlussleiste (400) bilden.

7. Klemmenabdeckung (200) nach Anspruch 6, **dadurch gekennzeichnet, dass** die Öffnungen (208) auch Nuten (207) zur Aufnahme von Steckern (102) aufweisen.

8. Klemmenabdeckung (200) nach Anspruch 6 oder 7, **dadurch gekennzeichnet, dass** sie Montagewände (205) und einen Befestigungsclip (209) zur Montage der Klemmenabdeckung (200) am Gehäuse (300) aufweist.

9. Klemmenabdeckung (200) nach einem der Ansprüche 6-8, **dadurch gekennzeichnet, dass** sie eine Aussparung (210) für einen Schraubendreher aufweist, der zum Trennen der Klemmenabdeckung (200) vom Gehäuse (300) verwendet wird.

10. Bausatz umfassend mindestens einen Stecker (100) nach einem der Ansprüche 1 - 4 oder mindestens eine Steckerpackung nach Anspruch 5 sowie mindestens eine Klemmenabdeckung (200) nach einem der Ansprüche 6 - 9.

11. Modulares Gehäuse (300) eines elektrischen und/oder elektronischen Gerätes, **dadurch gekennzeichnet, dass** es mindestens einen Stecker (100) nach einem der Ansprüche 1 - 4 oder mindestens eine Steckerpackung nach Anspruch 5 sowie mindestens eine Klemmenabdeckung (200) nach einem der Ansprüche 6 - 9 umfasst.

12. Modulares Gehäuse (300) nach Anspruch 11, **dadurch gekennzeichnet, dass** es zur Montage auf einer DIN-Schiene geeignet ist.

## Revendications

1. Fiche (100) adaptée pour être insérée dans un couvercle de bornes (200) pour un boîtier modulaire d'un dispositif électrique et/ou électronique, **caractérisée en ce qu'**elle comprend un corps (104) à insérer dans des rainures (206) du couvercle de bornes (200), où ledit corps est équipé d'une saillie (101) adaptée pour sceller des ouvertures (208) dans le couvercle de bornes (200) qui fournissent un accès à des vis (401) dans une barrette à bornes (400) du boîtier (300) et une dent (106) adaptée pour sceller une zone d'accès de fil dans un espace d'accès de fil (204) à la barrette à bornes (400) du boîtier (300).

2. Fiche (100), selon la revendication 1, **caractérisée en ce qu'**elle comprend au moins deux connecteurs (102).

3. Fiche (100), selon la revendication 1 ou 2, **caractérisée en ce que** le corps (104) de la fiche (100) comprend un biseau (105).

4. Fiche (100) selon la revendication 1 ou 2, **caractérisée en ce qu'**elle comprend un cylindre (103) placé coaxialement à la saillie.(101).

5. Paquet (100a) de fiches **caractérisé en ce qu'**il comprend au moins deux fiches (100) selon l'une quelconque des revendications 1 à 4, de préférence trois, reliées à l'aide de connecteurs (102).

6. Couvercle de bornes (200) pour un boîtier modulaire (300) d'un dispositif électrique et/ou électronique adapté pour recevoir au moins une fiche (100) selon l'une quelconque des revendications 1 à 4 ou au moins un paquet de fiches selon la revendication 5, où il comprend un corps (201) sous la forme d'un raccord angulaire allongé dont le premier élément, qui est le premier bras du raccord angulaire, comprend des ouvertures (208) donnant accès à des vis (401) dans la barrette à bornes (400) et adaptées pour recevoir des saillies (101) de fiches (100), tandis que le second élément, qui est le second bras du raccord angulaire, comprend sur son côté intérieur des rainures (206) adaptées pour recevoir des corps (104) de fiches (100) avec un ajustement à légère interférence et le second élément comprend des barres de borne saillantes (203) qui, avec le bord du second élément du couvercle de bornes (200), forment l'espace d'accès de fil (204) à la barrette à bornes (400).

7. Couvercle de bornes (200) selon la revendication 6, **caractérisé en ce que** les ouvertures (208) comprennent également des rainures (207) pour recevoir des connecteurs (102).

8. Couvercle de bornes (200) selon la revendication 6 ou 7, **caractérisé en ce qu'**il comprend des parois de montage (205) et un clip de fixation (209) pour monter le couvercle de bornes (200) sur le boîtier (300).

9. Couvercle de bornes (200) selon l'une quelconque des revendications 6 à 8, **caractérisé en ce qu'**il comprend un évidement (210) pour un tournevis utilisé pour déconnecter le couvercle de bornes (200) du boîtier (300).

10. Kit comprenant au moins une fiche (100) selon l'une quelconque des revendications 1 à 4 ou au moins un paquet de fiches selon la revendication 5 ainsi qu'au moins un couvercle de bornes (200) selon l'une quelconque des revendications 6 à 9.

11. Boîtier modulaire (300) d'un dispositif électrique et/ou électronique, **caractérisé en ce qu'**il comprend au moins une fiche (100) selon l'une quelconque des revendications 1 à 4 ou au moins un paquet de fiches selon la revendication 5 ainsi qu'au moins un couvercle de bornes (200) selon l'une quelconque des revendications 6 à 9.

12. Boîtier modulaire (300) selon la revendication 11, **caractérisé en ce qu'**il est adapté pour être monté sur un rail DIN.
